# EUROPEAN PATENT APPLICATION

(11) **EP 2 532 467 A1**
(43) Date of publication of application: **12.12.2012**
(21) Application number: 11739784.4
(22) Date of filing: 02.02.2011
(51) Int. Cl.: B23K 26/00, B23K 26/42, H01L 31/04, B23K 101/42

(54) **METHOD FOR MANUFACTURING PHOTOELECTRIC CONVERSION DEVICE AND LIGHT BEAM IRRADIATION PROCESSING DEVICE**

(30) Priority: 03.02.2010 JP 2010022182
(71) Applicant: Sharp Kabushiki Kaisha, Osaka-shi, Osaka 545-8522 (JP)
(72) Inventor: TACHIBANA, Shinsuke, Osaka 545-8522 (JP); SHIMADA, Koji, Osaka 545-8522 (JP); SHICHIJO, Yoichi, Osaka 545-8522 (JP)
(74) Representative: Müller - Hoffmann & Partner
(86) International application number: PCT/JP2011/052151
(87) International publication number: WO 2011/096436

(57) **Abstract**

There is provided a method for producing a photoelectric conversion device in which an object to be processed (12) is processed by directing a light beam (22) to a position determined based on information including temperature information and distortion information acquired in advance. There is also provided a light beam irradiation processing apparatus including a control portion (17) capable of controlling a light beam generating portion (11) and a drive portion (16a, 16b) in such a manner that a light beam (22) can be directed to a position determined based on information including temperature information acquired by a temperature information acquiring portion (18, 52, 53) and distortion information stored therein.

## Description

### TECHNICAL FIELD

The present invention relates to a method for producing a photoelectric conversion device, and a light beam irradiation processing apparatus.

### BACKGROUND ART

Representative structures of a thin-film solar battery, which is one example of a photoelectric conversion device, are the following two structures (1) and (2), for example:
(1) a structure in which a transparent conductive film such as SnO₂ (tin oxide), ITO (Indium Tin Oxide), or ZnO (zinc oxide) is formed on a translucent insulating substrate such as glass, a photoelectric conversion layer including a semiconductor p layer, a semiconductor i layer, and a semiconductor n layer stacked in this order is formed on the transparent conductive film, and a back electrode layer such as a metal thin film is formed on the photoelectric conversion layer; and
(2) a structure in which a photoelectric conversion layer including a semiconductor n layer, a semiconductor i layer, and a semiconductor p layer stacked in this order is formed on a metal substrate electrode, and a transparent conductive film is formed on the photoelectric conversion layer.

Structure (1) has come into frequent use and is the current mainstream because the translucent insulating substrate can also serve as a surface protection member of the thin-film solar battery, and the formation of the photoelectric conversion layer on the plasma-resistant transparent conductive film, such as SnO₂, by plasma CVD has become possible.

With regard to structure (1), attempts to improve the conversion efficiency of the thin-film solar battery have also been made by using a high-reflectance material such as Ag (silver) or Al (aluminum) as the back electrode layer of the thin-film solar battery, and by sandwiching the transparent electrode, such as ZnO or ITO, between the photoelectric conversion layer and the back electrode layer.

Moreover, a method in which unit solar cells are integrated and connected in series on a translucent insulating substrate by using laser light is generally employed for structure (1), in order to produce a thin-film solar battery having a surface with an increased area.

This method is performed as follows, for example. Initially, a transparent conductive film including a separation groove for separating a transparent conductive film is formed on a translucent insulating substrate. Next, a photoelectric conversion layer is stacked to cover the transparent conductive film provided with the separation groove, and a separation groove for separating the photoelectric conversion layer is formed by removing a portion of the photoelectric conversion layer by a laser scribing method using laser light. A back electrode layer is then stacked to cover the photoelectric conversion layer having the separation groove formed therein, and a separation groove for separation into unit solar cells is formed by removing a portion of each of the photoelectric conversion layer and the back electrode layer by the laser scribing method using laser light. In this way, a thin-film solar battery can be formed in which the transparent conductive film of a unit solar cell formed of the single transparent conductive film, photoelectric conversion layer, and back electrode layer is electrically connected to the back electrode layer of an adjacent unit solar cell on the translucent insulating substrate.

Furthermore, in the thin-film solar battery having unit solar cells integrated on the translucent insulating substrate, the conversion efficiency of the thin-film solar battery is improved by reducing the non-power generating area. As a method for reducing the non-power generating area, reducing a distance between the separation groove for separating the transparent conductive film and the separation groove for separating the photoelectric conversion layer, and a distance between the separation groove for separating the photoelectric conversion layer and the separation groove for separating a unit solar cell has been considered. It is necessary to perform laser scribing processing with good precision to reduce each of these distances and thereby improve the production efficiency of the thin-film solar battery.

With laser scribing processing, however, separation grooves could not be formed with good precision, and due to variation in the positions in which the separation grooves are formed, problems such as deteriorated characteristics of the thin-film solar battery, and poor electrical contact between unit solar cells constituting the thin-film solar battery occurred.

In order to solve this problem, PTL 1 (Japanese Patent Laying-Open No. 2000-353816), for example, discloses a method for producing a thin-film solar battery in which the substrate temperature during laser scribing of each of the transparent conductive film, the photoelectric conversion layer, and the back electrode layer is adjusted to be within the range of ± 10 °C of a set value. According to this method, high-precision laser scribing can be realized by reducing variation in substrate temperature during laser scribing.

The method described in PTL 1, however, had a problem in that due to cooling of the substrate, a considerable time is required to lower the substrate temperature around room temperature, each after the formation of the photoelectric conversion layer by plasma CVD, the formation of the transparent conductive film by sputtering, and the formation of the back electrode layer by sputtering.

As a method for cooling the substrate, natural cooling or forced fan cooling can be used.

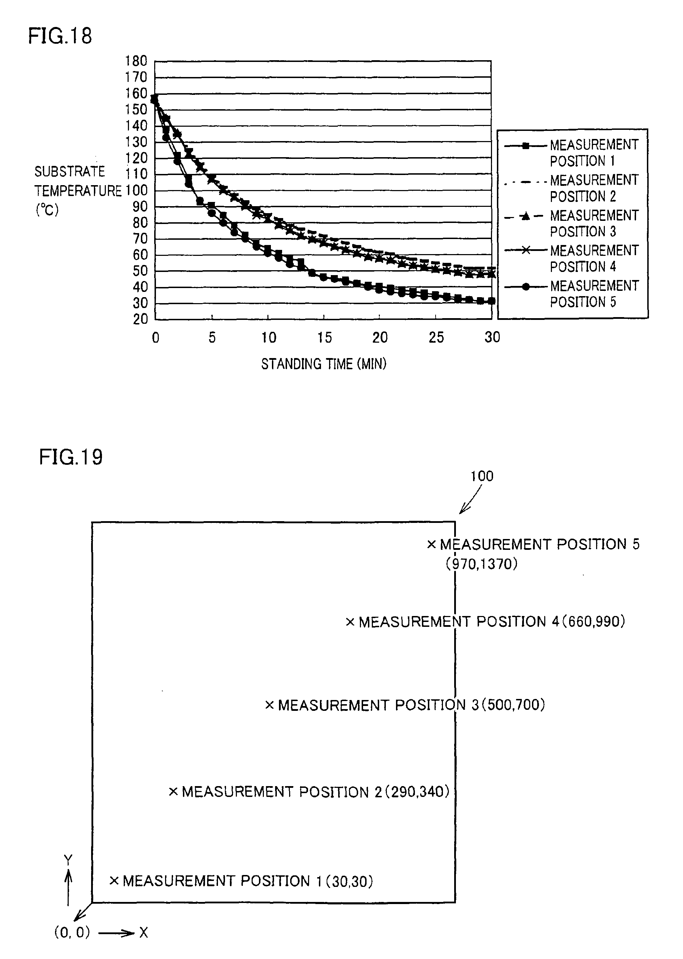

Fig. 18 shows the relationship between substrate temperature (°C) and standing time (min) at each of measurement positions 1 to 5 when a glass substrate at 160°C, having dimensions of 1000 mm in width x 1400 mm in length x 4 mm in thickness, is naturally cooled by being left to stand for 30 minutes. The vertical axis in Fig. 18 represents substrate temperature (°C), and the horizontal axis represents standing time (min).

Fig. 19 depicts a schematic plan view showing the positions of measurement positions 1 to 5 on the surface of above-described glass substrate 100. Here, when the coordinates (x, y) of the lower left corner on the surface of glass substrate 100 are defined as (0, 0), the width direction of glass substrate 100 is defined as the x-axis, and the longitudinal direction is defined as the y-axis, the coordinates (x, y) of each of measurement positions 1 to 5 are as follows: measurement position 1 (30, 30), measurement position 2 (290, 340), measurement position 3 (500, 700), measurement position 4 (660, 990), and measurement position 5 (970, 1370).

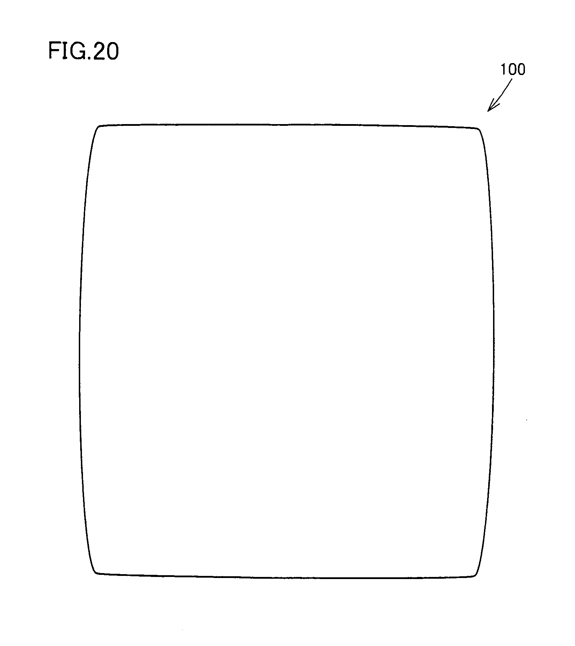

As shown in Figs. 18 and 19, when glass substrate 100 at 160°C is naturally cooled by being left to stand for 30 minutes, the substrate temperatures on a central portion of the surface of glass substrate 100 (measurement positions 2 to 4) after natural cooling are about 50°C, and the substrate temperatures on a perimeter portion thereof (measurement positions 1 and 5) are about 30°C, thus producing a temperature difference of about 20°C within glass substrate 100. In this case, glass substrate 100 undergoes thermal expansion, as shown in the schematic plan view of Fig. 20, for example. Therefore, even if laser scribing is applied to such thermally expanded glass substrate 100, high-precision laser scribing cannot be realized. For this reason, when glass substrate 100 is cooled by natural cooling in the method described in PTL 1, it is necessary to cool the substrate for 30 minutes or longer each after the formation of each of the transparent conductive film, the photoelectric conversion layer, and the back electrode layer, and a long cooling time is further required to maintain in-plane uniformity of glass substrate 100, in order to perform laser processing with good precision, thus inviting the problem of poor production efficiency of the thin-film solar battery. The photoelectric conversion layer, in particular, is an important layer that affects the characteristics of a thin-film solar battery, and hence, it is crucial to perform the subsequent step in a short time after the formation of the photoelectric conversion layer.

When forced fan cooling is used as the method for cooling the substrate, although the cooling time can be shortened as compared to the case of using natural cooling, a cooling time of 30 minutes or longer is needed in this case also, in order to realize high-precision laser scribing. Forced fan cooling also has the problem of increased costs of the production apparatus.

For this reason, PTL 2 (Japanese Patent No. 4354282), for example, discloses a method for realizing high-precision laser scribing and improved production efficiency of a thin-film solar battery, by actively adjusting the substrate temperature.

### CITATION LIST

### PATENT LITERATURE

PTL 1: Japanese Patent Laying-Open No. 2000-353816
PTL 2: Japanese Patent No. 4354282

### SUMMARY OF INVENTION

### TECHNICAL PROBLEM

In the method described in PTL 2, however, when the production line has stopped for a long time and the substrate temperature has lowered to room temperature, for example, it is necessary to heat the substrate to a set value higher than room temperature (see paragraphs [0024] and [0029] of PTL 2), thus causing the problem of lowered production efficiency of the thin-film solar battery. Moreover, in order to avoid heating of the substrate whose temperature has lowered to room temperature, it is necessary to introduce an apparatus or the like for maintaining the temperature of the entire production line at the temperature of the set value, which increases the costs for the entire production apparatus. Furthermore, in the method described in PTL 2 also, a cooling time is needed for lowering the substrate temperature that is higher than the set value down to the set value.

In view of the above-described circumstances, an object of the present invention is to provide a method for producing a photoelectric conversion device and a light beam irradiation processing apparatus that are capable of realizing high production efficiency with high-precision processing, without the need to adjust the substrate temperature.

### SOLUTION TO PROBLEM

The present invention is directed to a method for producing a photoelectric conversion device including the steps of acquiring temperature information on an object to be processed including a substrate and a film formed on the substrate, and processing the object to be processed by directing a light beam to the object to be processed subsequent to the step of acquiring the temperature information, thereby processing a region of the object to be processed irradiated with the light beam, wherein in the step of processing the object to be processed, the light beam is directed to a position determined based on information including the temperature information and distortion information acquired in advance.

Preferably, in the method for producing a photoelectric conversion device according to the present invention, information on a temperature distribution over a surface of the object to be processed or a temperature at at least one point of the surface of the object to be processed is acquired in the step of acquiring the temperature information.

Preferably, in the method for producing a photoelectric conversion device according to the present invention, the light beam is directed from a substrate side in the step of processing the object to be processed.

Moreover, the present invention is directed to a light beam irradiation processing apparatus for processing an object to be processed including a substrate and a film formed on the substrate by directing a light beam to the object to be processed. The light beam irradiation processing apparatus includes a light beam generating portion for directing the light beam to the object to be processed, a temperature information acquiring portion for acquiring temperature information on the object to be processed before directing the light beam, a drive portion capable of changing a position of the object to be processed, and a control portion capable of controlling the light beam generating portion and the drive portion in such a manner that the light beam can be directed to a position determined based on information including the temperature information acquired by the temperature information acquiring portion and distortion information stored therein.

Furthermore, the present invention is directed to a light beam irradiation processing apparatus for processing an object to be processed including a substrate and a film formed on the substrate by directing a light beam to the object to be processed. The light beam irradiation processing apparatus includes a temperature information acquiring portion for acquiring temperature information on the object to be processed, a processing portion for processing the object to be processed, and a transport portion for transporting the object to be processed from the temperature information acquiring portion to the processing portion. The processing portion includes a light beam generating portion for directing the light beam to the object to be processed, a drive portion capable of changing a position of the object to be processed, and a control portion capable of controlling the light beam generating portion and the drive portion in such a manner that the light beam can be directed to a position determined based on information including the temperature information acquired by the temperature information acquiring portion and distortion information stored therein.

### ADVANTAGEOUS EFFECTS OF INVENTION

According to the present invention, a method for producing a photoelectric conversion device and a light beam irradiation processing apparatus can be provided that are capable of realizing high production efficiency with high-precision processing, without the need to adjust the substrate temperature.

### BRIEF DESCRIPTION OF DRAWINGS

Fig. 1 is a schematic cross-sectional view illustrating one production step of a method for producing a thin-film solar battery according to an embodiment.
Fig. 2 is a schematic cross-sectional view illustrating another production step of the method for producing a thin-film solar battery according to the embodiment.
Fig. 3 is a schematic cross-sectional view illustrating still another production step of the method for producing a thin-film solar battery according to the embodiment.
Fig. 4 is a schematic cross-sectional view illustrating yet another production step of the method for producing a thin-film solar battery according to the embodiment.
Fig. 5 is a schematic structural diagram of one exemplary laser scribing apparatus used in the embodiment.
Fig. 6 is a schematic perspective view illustrating one step of one exemplary method for acquiring in advance distortion information on a solar battery substrate.
Fig. 7 is a schematic enlarged plan view illustrating another step of the exemplary method for acquiring in advance distortion information on a solar battery substrate.
Fig. 8 is a schematic enlarged plan view illustrating another exemplary method for acquiring in advance distortion information on a solar battery substrate.
Fig. 9 is a schematic enlarged plan view illustrating yet another exemplary method for acquiring in advance distortion information on a solar battery substrate.
Fig. 10 is a schematic structural diagram of another exemplary laser scribing apparatus used in the embodiment.
Fig. 11 is a schematic structural diagram of still another exemplary laser scribing apparatus used in the embodiment.
Fig. 12 is a schematic cross-sectional view illustrating still another production step of the method for producing a thin-film solar battery according to the embodiment.
Fig. 13 is a schematic cross-sectional view illustrating yet another production step of the method for producing a thin-film solar battery according to the embodiment.
Fig. 14 is a schematic enlarged plan view illustrating an exemplary relationship between a first separation groove, a second separation groove, and a third separation groove in a thin-film solar battery produced according to the embodiment.
Fig. 15 is a photograph showing a temperature distribution over a surface of a solar battery substrate measured by infrared thermography in Example.
Fig. 16 is a photograph of the thin-film solar battery according to the Example, taken from the substrate side using an optical microscope.
Fig. 17 is a photograph of a thin-film solar battery according to Comparative Example, taken from the substrate side using an optical microscope.
Fig. 18 is a diagram showing the relationship between substrate temperature (°C) and standing time (min) at each of measurement positions 1 to 5 when a glass substrate at 160°C is naturally cooled by being left to stand for 30 minutes.
Fig. 19 is a schematic plan view showing the positions of measurement positions 1 to 5 on the surface of the glass substrate.
Fig. 20 is a schematic plan view of a thermally expanded glass substrate.

### DESCRIPTION OF EMBODIMENTS

A method for producing a thin-film solar battery according to an embodiment will be described hereinafter, as one exemplary method for producing a photoelectric conversion device according to the present invention. In the drawings of the present invention, the same or corresponding elements are denoted by the same reference characters.

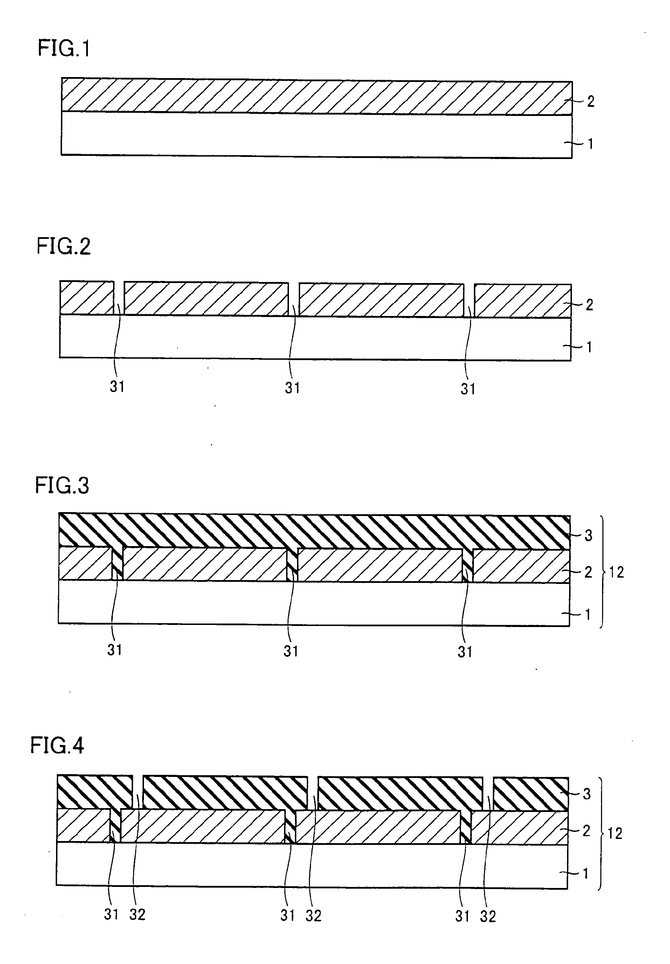

Initially, as shown in the schematic cross-sectional view of Fig. 1, a transparent conductive film 2 is formed on a substrate 1. A conventionally known method such as thermal CVD, sputtering, vacuum deposition, or ion plating, for example, may be used as the method for forming transparent conductive film 2.

As substrate 1, a translucent substrate through which light can pass may be used, for example, a glass substrate, a resin substrate containing a transparent resin such as a polyimide resin, or a substrate obtained by stacking a plurality of these substrates.

As transparent conductive film 2, a conductive film through which light can pass may be used, for example, a single layer of an SnO₂ (tin oxide) film, an ITO (Indium Tin Oxide) film, or a ZnO (zinc oxide) film, or a plurality of layers obtained by stacking a plurality of these layers. Where transparent conductive film 2 is composed of a plurality of layers, all of the layers may be formed of the same material, or at least one layer may be formed of a material different from that of the others.

Next, as shown in the schematic cross-sectional view of Fig. 2, a straight first separation groove 31 for separating transparent conductive film 2 is formed. First separation groove 31 may be formed by the laser scribing method, for example. First separation groove 31 may be formed by the laser scribing method as follows, for example. Laser light is directed to a portion of transparent conductive film 2 from the substrate 1 side, the position irradiated with the laser light is moved along the surface of transparent conductive film 2, and the portion of the region of transparent conductive film 2 irradiated with the laser light is vaporized. As the laser light used for forming first separation groove 31 by the laser scribing method, the fundamental wave of YAG laser light or the fundamental wave of YVO₄ laser light, for example, may be used.

Next, as shown in the schematic cross-sectional view of Fig. 3, a photoelectric conversion layer 3 is formed on transparent conductive film 2 having first separation groove 31 formed therein to thereby form a solar battery substrate 12. Plasma CVD, for example, may be used as the method for forming photoelectric conversion layer 3.

As photoelectric conversion layer 3, a stacked structure obtained by stacking a p-type semiconductor layer, an i-type semiconductor layer, and an n-type semiconductor layer in this order from the substrate 1 side by plasma CVD, for example, may be used.

As the p-type semiconductor layer, a single layer of a p-type layer such as a p-type amorphous silicon layer, a p-type microcrystalline silicon layer, a p-type amorphous silicon carbide layer, or a p-type amorphous silicon nitride layer, or a plurality of layers obtained by stacking a plurality of these layers may be used, for example. Where the p-type semiconductor layer is composed of a plurality of layers, all of the layers may be formed of the same semiconductor material, or at least one layer may be formed of a semiconductor material different from that of the others. Boron, for example, may be used as a p-type impurity to be doped into the p-type semiconductor layer.

As the i-type semiconductor layer, a single layer of an i-type layer such as an i-type amorphous silicon layer, an i-type microcrystalline silicon layer, an i-type amorphous silicon carbide layer, or an i-type amorphous silicon nitride layer, or a plurality of layers obtained by stacking a plurality of these layers may be used, for example. The i-type semiconductor layer is a non-doped layer doped with neither a p-type nor n-type impurity. Where the i-type semiconductor layer is composed of a plurality of layers, all of the layers may be formed of the same semiconductor material, or at least one layer may be formed of a semiconductor material different from that of the others.

As the n-type semiconductor layer, a single layer of an n-type layer such as an n-type amorphous silicon layer, an n-type microcrystalline silicon layer, an n-type amorphous silicon carbide layer, or an n-type amorphous silicon nitride layer, or a plurality of layers obtained by stacking a plurality of these layers may be used, for example. Where the n-type semiconductor layer is composed of a plurality of layers, all of the layers may be formed of the same semiconductor material, or at least one layer may be formed of a semiconductor material different from that of the others. Phosphorus, for example, may be used as an n-type impurity to be doped into the n-type semiconductor layer.

Alternatively, photoelectric conversion layer 3 may have a tandem structure in which two or more p-i-n layers are stacked, for example. Such a tandem structure may, for example, be a structure having a combination of a p-i-n layer obtained by stacking a p-type amorphous silicon layer, an i-type amorphous silicon layer, and an n-type microcrystalline silicon layer in this order from the substrate 1 side, and a p-i-n layer obtained by stacking a p-type microcrystalline silicon layer, an i-type microcrystalline silicon layer, and an n-type microcrystalline silicon layer in this order from the substrate 1 side.

In the present specification, the term "amorphous silicon" denotes a concept that includes "hydrogenated amorphous silicon", and the term "microcrystalline silicon" denotes a concept that includes "hydrogenated microcrystalline silicon".

Next, as shown in the schematic cross-sectional view of Fig. 4, a straight second separation groove 32 for separating photoelectric conversion layer 3 of solar battery substrate 12 is formed. Second separation groove 32 is formed by the laser scribing processing described hereinafter by way of example.

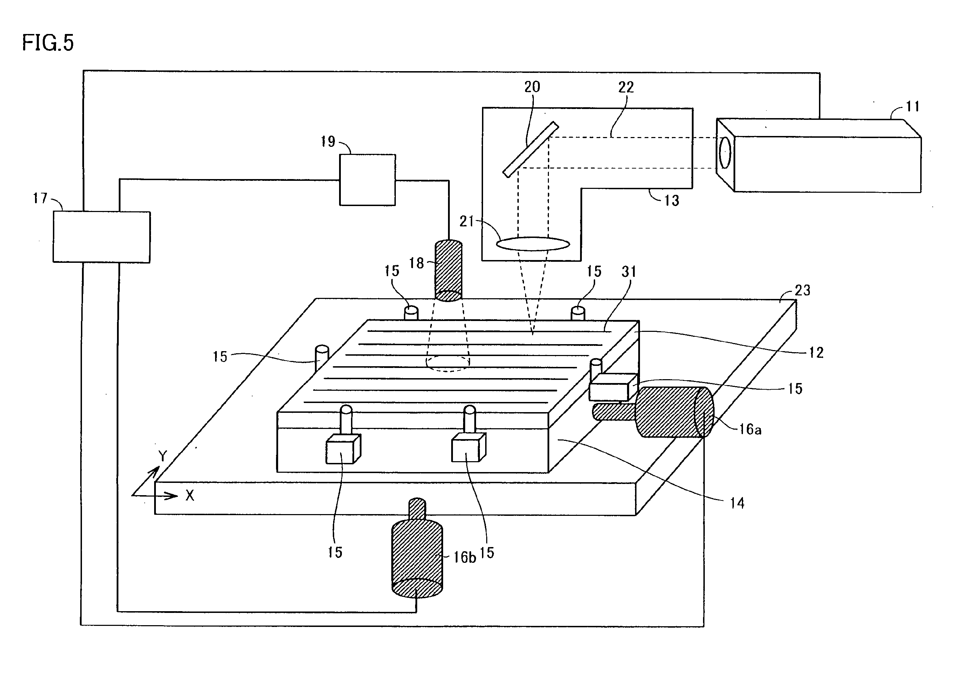

Fig. 5 is a schematic structure of an exemplary laser scribing apparatus used in the present embodiment. This laser scribing apparatus includes a laser light generator 11, which corresponds to a light beam generating portion, an optical unit 13, which corresponds to a processing portion, a stage 14, a substrate position fixing unit 15, a substrate flatness maintaining member (not shown), drive units 16a, 16b, which correspond to a drive potion, a base 23, a temperature measuring unit 18, a temperature information recording unit 19, and a control unit 17, which corresponds to a control portion.

Laser light generator 11 can generate laser light 22 having such energy that can vaporize photoelectric conversion layer 3 of solar battery substrate 12. Laser light 22 may, for example, be a second harmonic wave of YAG laser light or a second harmonic wave of YVO₄ laser light.

Optical unit 13 is implemented by an optical system of the space transmission system including a mirror 20 that can change by reflection the direction of travel of laser light 22 generated from laser light generator 11, and a lens 21 that can converge laser light 22 reflected by mirror 20 and direct it to solar battery substrate 12. Optical unit 13 is not particularly limited so long as it is an optical system that can guide laser light 22 generated from laser light generator 11 to solar battery substrate 12, and an optical system of the fiber transmission system using optical fibers, for example, may also be used in place of the optical system of the space transmission system.

Stage 14 is implemented by a stage having such a structure that solar battery substrate 12 can be placed on a surface thereof (for example, a support member capable of holding a perimeter portion of solar battery substrate 12).

Substrate position fixing unit 15 is implemented by a mechanism that is attached to each of the four side surfaces of stage 14 to hold side surfaces of solar battery substrate 12, thereby preventing a positional change of solar battery substrate 12 relative to stage 14. Substrate position fixing unit 15, however, is not limited to such a mechanism, and any mechanism for fixing solar battery substrate 12 on stage 14 may be used.

The substrate flatness maintaining member (not shown) is provided inside stage 14, has a tip portion made of resin, and maintains the flatness of the surface of solar battery substrate 12 by supporting solar battery substrate 12 at a plurality of points. The substrate flatness maintaining member (not shown) may be implemented by a holding pin or a ball bearing, for example. In place of the substrate flatness maintaining member (not shown), a mechanism having an autofocus function and responding to a deflection of solar battery substrate 12 may also be provided.

When a longitudinal direction of the surface of base 23 is defined as the x-axis, and a direction orthogonal to the longitudinal direction of the surface of base 23 is defined as the y-axis, a mechanism for moving stage 14 freely in the x-axial direction of the surface of base 23 is used as drive unit 16a, and a mechanism for moving stage 14 freely in the y-axial direction of the surface of base 23 is used as drive unit 16b. Drive units 16a, 16b, however, are not limited to those having this structure, and any drive units that allow stage 14 holding solar battery substrate 12 to move two-dimensionally on the surface of base 23 may be used.

Base 23 is implemented by a flat plate having a surface on which stage 14 can be moved two-dimensionally.

Temperature measuring unit 18 is located above solar battery substrate 12 and can acquire temperature information on solar battery substrate 12. Temperature measuring unit 18 is not particularly limited so long as it can acquire temperature information on solar battery substrate 12, and may be implemented by, for example, non-contact type infrared thermography that can acquire information on a temperature distribution over the entire surface of solar battery substrate 12, or a non-contact type infrared radiation thermometer or a contact-type thermocouple that can measure the temperature of the surface of solar battery substrate 12 in a spot.

Temperature information recording unit 19 is connected to each of temperature measuring unit 18 and control unit 17. Temperature information recording unit 19 can receive temperature information on solar battery substrate 12 sent from temperature measuring unit 18 and record it therein, and can send the recorded temperature information to control unit 17.

Control unit 17 is connected to each of laser light generator 11, drive unit 16a, drive unit 16b, and temperature information recording unit 19. Control unit 17 also has stored therein distortion information on solar battery substrate 12 acquired in advance. Control unit 17 can then determine a position on solar battery substrate 12 to be irradiated with laser light 22 generated from laser light generator 11, based on the temperature information on solar battery substrate 12 sent from temperature information recording unit 19 and the distortion information on solar battery substrate 12 stored therein, and can control the timing of directing laser light 22 generated from laser light generator 11 and movement of stage 14 by way of drive units 16a, 16b, in such a manner that laser light 22 is directed to the determined position to be irradiated.

The distortion information on solar battery substrate 12 is the information about an amount of distortion with respect to a temperature in at least one position of the surface of solar battery substrate 12, and is acquired in advance before laser scribing processing of solar battery substrate 12.

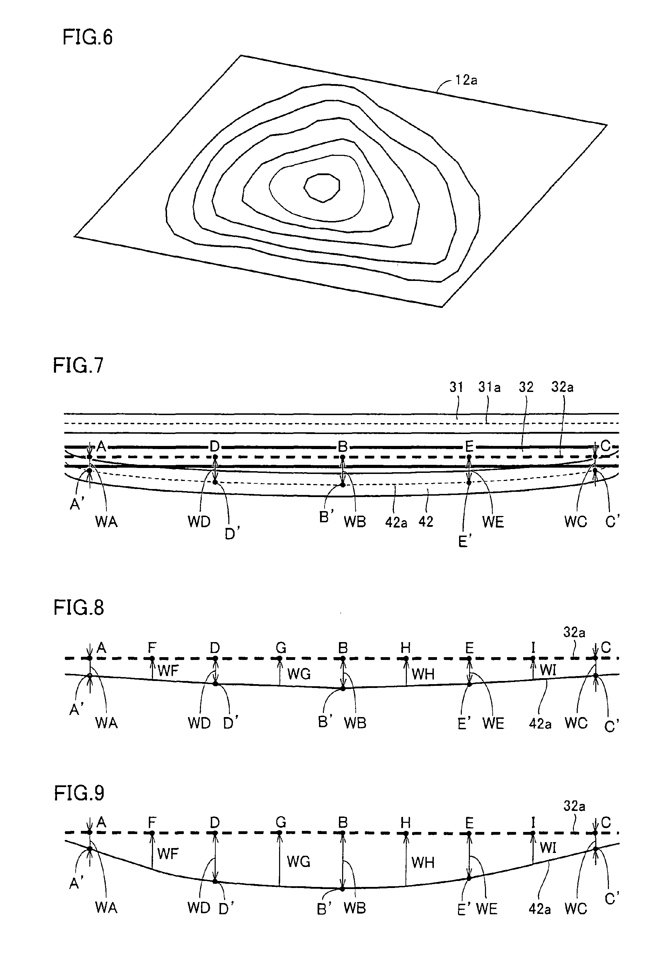

The distortion information on solar battery substrate 12 can be acquired in advance in accordance with the following manners (a) to (d), for example.
(a) When fabricating the same sample as solar battery substrate 12 that is the object to be processed, at least one predetermined position on the surface of substrate 1 at room temperature (preferably, three points including the center and opposing edges of the surface of substrate 1) is specified in advance, after the formation of first separation groove 31 and before the formation of photoelectric conversion layer 3. The predetermined position is herein specified in terms of the distance from a reference position (for example, a side surface of substrate 1), of which position does not change due to a change in the temperature of the object to be processed.
(b) Photoelectric conversion layer 3 is next formed on the surface of transparent conductive film 2 having first separation groove 31 formed therein, thereby fabricating the same sample as solar battery substrate 12 that is the object to be processed.
(c) Next, as shown in the schematic perspective view of Fig. 6, for example, a temperature distribution over a surface of a sample 12a immediately after the formation of photoelectric conversion layer 3 is measured.
(d) Next, as shown in the schematic enlarged plan view of Fig. 7, for example, points A to E corresponding to the predetermined positions specified in (a) above move to points A' to E', respectively, due to a distortion caused by the formation of photoelectric conversion layer 3. The distance to each of points A' to E' from the reference position is then measured as in (a) above. The absolute value of the difference between the distance from each of points A' to E' from the reference position and the distance from each of points A to E from the reference position specified in (a) above is then calculated. Consequently, information on the relationship between the temperature at each of points A to E corresponding to the predetermined positions specified in (a) above and each of the amounts of distortion WA, WB, WC, WD, and WE, respectively, can be acquired. In Fig. 7, reference character 42 corresponds to the below-described path of the position irradiated with laser light 22, and the curve passing from points A' to E' corresponds to a processing center line 42a, which is the center line of the width of path 42. The center line of the width of first separation groove 31 corresponds to a processing center line 31 a of first separation groove 31.

In the foregoing description, each of points A to E corresponds to each of the following points.

Point A: a point near one end portion of processing center line 32a, which corresponds to the center line in the width direction of straight second separation groove 32, formed in an ideal position after cooling to room temperature following the laser scribing processing.

Point B: a midpoint of processing center line 32a of straight second separation groove 32, formed in an ideal position after cooling to room temperature following the laser scribing processing.

Point C: a point near an end portion of processing center line 32a opposite to point A of straight second separation groove 32, formed in an ideal position after cooling to room temperature following the laser scribing processing.

Point D: a midpoint of a line segment AB connecting points A and B on processing center line 32a of straight second separation groove 32, formed in an ideal position after cooling to room temperature following the laser scribing processing.

Point E: a midpoint of a line segment BC connecting points B and C on processing center line 32a of straight second separation groove 32, formed in an ideal position after cooling to room temperature following the laser scribing processing.

Furthermore, as shown in Fig. 8 or 9, for example, an amount of distortion for a point in addition to above-described points A to E can also be calculated. As a method for calculating an amount of distortion for a point in addition to points A to E, how an amount of distortion for each of a point F (a midpoint of a line segment AD connecting points A and D), a point G (a midpoint of a line segment DB connecting points D and B), a point H (a midpoint of a line segment BE connecting points B and E), and a point I (a midpoint of a line segment EC connecting points E and C) is calculated will now be described.

Fig. 8 illustrates a method for calculating an amount of distortion at each of points F to I, assuming that when the distance between processing center line 31a of first separation groove 31 and processing center line 32a of second separation groove 32 is about 50 µm, the difference between the amounts of each pair of adjacent distortions (WD-WA, WB-WD, WB-WE, and WE-WC) is 20 µm or less.

Initially, as shown in Fig. 8, a curved line that connects a straight line or an approximate straight line passing each of points A', D', and B' and a straight line or an approximate straight line passing each of points B', E', and C' is drawn.

Next, by measuring the distance between the above curved line and each of points F to I on processing center line 32a, each of an amount of distortion WF, WG, WH, and WI at respective points F to I is calculated.

Fig. 9 illustrates a method for calculating an amount of distortion at each of points F to I, assuming that when the distance between processing center line 31a of first separation groove 31 and processing center line 32a of second separation groove 32 is about 50 µm, the difference between the amounts of at least one of the pairs of adjacent distortions (WD-WA, WB-WD, WB-WE, and WE-WC) exceeds 20 µm.

Initially, as shown in Fig. 9, a curve or an approximate curve passing each of points A' to E' is drawn.

Next, by measuring the distance between the above curve or approximate curve and each of points F to I on processing center line 32a, each of an amount of distortion WF, WG, WH, and WI at respective points F to I is calculated.

As described above, by calculating an amount of distortion in a predetermined position on the surface of sample 12a while varying the temperature distribution over the surface of sample 12a, it is possible to acquire distortion information, which is the information about the amount of distortion with respect to the temperature in the predetermined position on the surface of solar battery substrate 12.

In the foregoing description, the distortion information on solar battery substrate 12 is acquired from a plurality of points on processing center line 32a of straight second separation groove 32 formed in the ideal position after cooling to room temperature following the laser scribing processing; however, distortion information at a plurality of points on the surface of solar battery substrate 12 can also be acquired from a representative single point (preferably, a point having the highest temperature after the formation of photoelectric conversion layer 3), in the same manner as described above. This is because when thin-film solar batteries having the same structure are mass-produced through the same production steps, the temperature distribution of solar battery substrate 12 shows substantially the same tendency.

Moreover, distortion information is preferably acquired in advance in the same manner as above, also for substrate 1 after the formation of transparent conductive film 2 and before the formation of first separation groove 31 and for solar battery substrate 12 after the formation of the below-described back electrode layer and before the formation of the below-described third separation groove.

One exemplary method for forming second separation groove 32 by laser scribing processing of solar battery substrate 12 using the laser scribing apparatus shown in Fig. 5 will be described hereinafter.

Initially, as shown in Fig. 5, solar battery substrate 12, which is the object to be processed, is placed on stage 14 and then fixed on stage 14 with substrate position fixing unit 15.

Next, temperature information on the surface of solar battery substrate 12 is acquired by temperature measuring unit 18, and the acquired temperature information on the surface of solar battery substrate 12 is sent to temperature information recording unit 19 and recorded therein.

The temperature information recorded in temperature information recording unit 19 is next sent to control unit 17 from temperature information recording unit 19. Control unit 17 then determines the position to be irradiated with laser light 22 such that straight second separation groove 32 is formed in solar battery substrate 12 after being cooled to room temperature, based on the temperature information sent from temperature information recording unit 19 and the distortion information on solar battery substrate 12 acquired in advance and stored in control unit 17. The position to be irradiated with laser light 22 may be determined further in consideration of the pitch of second separation grooves 32.

Next, control unit 17 controls laser light generator 11 and drive units 16a, 16b such that laser light 22 is directed from laser light generator 11 while stage 14 is being moved two-dimensionally in the x-axial direction and/or the y-axial direction of base 23 by drive units 16a, 16b, whereby laser light 22 is directed along a path of the position to be irradiated with laser light 22 determined as above. Irradiation of laser light 22 may be performed here based on a processing reference (preferably, a side surface of substrate 1 located in the width direction of first separation groove 31).

Laser light 22, after being generated from laser light generator 11, proceeds into optical unit 13, where it is reflected by mirror 20 inside optical unit 13 and converged by lens 21, and subsequently enters solar battery substrate 12 from the substrate 1 side. Laser light 22 incident from the substrate 1 side of solar battery substrate 12 is directed to photoelectric conversion layer 3 through substrate 1 and transparent conductive film 2, vaporizing and removing the portion irradiated with laser light 22 to form second separation groove 32.

The path of the position irradiated with laser light 22 has been determined by assuming how a distortion is generated after the temperature distribution of solar battery substrate 12 has changed from the state before the laser scribing processing to the state after being cooled to room temperature. Therefore, although the shape of second separation groove 32 is formed along the above-determined path immediately after the laser scribing processing, after solar battery substrate 12 is cooled to room temperature following the above-described processing, the distortion generated in solar battery substrate 12 is eliminated, so that the shape of second separation groove 32 becomes straight to form straight second separation groove 32.

The fixing with substrate position fixing unit 15 is then released, and solar battery substrate 12 after the formation of second separation groove 32 is taken out from stage 14, completing the laser scribing processing of solar battery substrate 12.

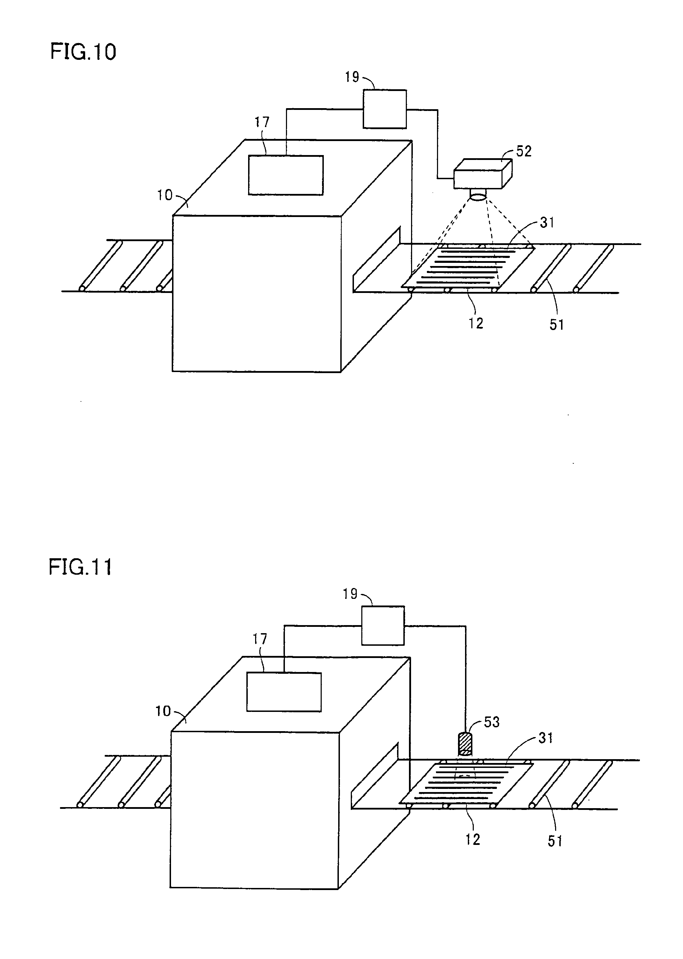

Fig. 10 is a schematic structure of another exemplary laser scribing apparatus used in the present embodiment. This laser scribing apparatus has a feature in that it transports solar battery substrate 12, which corresponds to the object to be processed, using a conveyor 51, which corresponds to a transport portion, and acquires a temperature distribution over the entire surface of solar battery substrate 12 as temperature information using infrared thermography 52, before transporting solar battery substrate 12 into laser beam irradiation apparatus 10.

With the laser scribing apparatus shown in Fig. 10, solar battery substrates 12 can be continuously processed because the temperature information of another solar battery substrate 12 can be acquired in advance with infrared thermography 52, during processing of solar battery substrate 12 in laser beam irradiation apparatus 10.

Laser beam irradiation apparatus 10 may be implemented by, for example, a laser beam irradiation apparatus obtained by taking out temperature measuring unit 18 and temperature information recording unit 19 of the laser scribing apparatus shown in Fig. 5 from the inside of the apparatus.

Fig. 11 shows a schematic structure of still another exemplary laser scribing apparatus used in the present embodiment. This laser scribing apparatus has a feature in that it uses an infrared radiation thermometer 53 capable of measuring the surface temperature of solar battery substrate 12 in a spot as a temperature measuring device, before transporting solar battery substrate 12 into laser beam irradiation apparatus 10.

In the laser scribing apparatus shown in Fig. 11, infrared radiation thermometer 53 can be installed at a cost lower than that for infrared thermography 52 of the laser scribing apparatus shown in Fig. 10, and thus a reduction in apparatus costs can be achieved. Moreover, in this case, it is preferable to acquire not only the temperature information on the center of solar battery substrate 12 but also the temperature information on at least an edge of solar battery substrate 12 by using infrared radiation thermometer 53, to monitor the difference in temperature between the center and the edge of solar battery substrate 12. In this way, it can be confirmed whether the temperature distribution of each solar battery substrate 12 falls within a normal range of temperature distributions of solar battery substrate 12 or not, thus improving the precision of the laser scribing processing of solar battery substrate 12.

Where the method for acquiring temperature information of solar battery substrate 12 is conducted by detecting an infrared spectrum emitted from solar battery substrate 12 outside laser beam irradiation apparatus 10, as shown in Figs. 10 and 11, it is preferable that a member surrounding the periphery of conveyor 51 be installed to prevent entry of light into solar battery substrate 12, in order to avoid influence of a fluorescent lamp or the like on the temperature information.

Furthermore, where the method for acquiring temperature information of solar battery substrate 12 is conducted by detecting an infrared spectrum emitted from solar battery substrate 12 outside laser beam irradiation apparatus 10, as shown in Figs. 10 and 11, an error in the measured temperature is preferably within the range of ± 2°C, more preferably ± 1 °C, and still more preferably ± 0.5°C, of the actual temperature. Furthermore, temperature information on solar battery substrate 12 is preferably acquired immediately before solar battery substrate 12 is transported into laser beam irradiation apparatus 10.

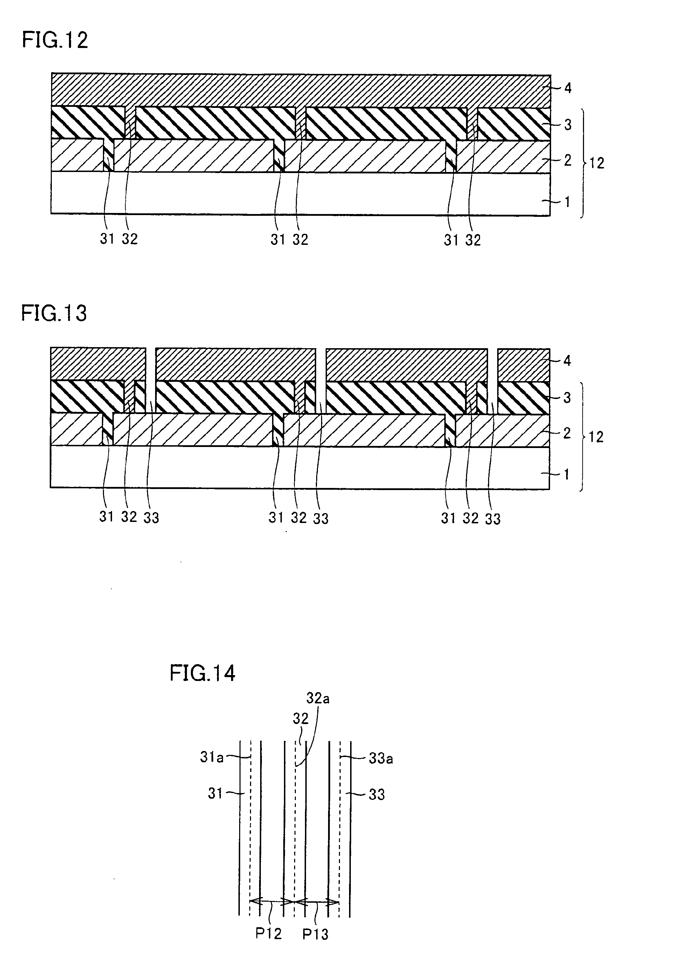

After forming second separation groove 32 for separating photoelectric conversion layer 3 as described above, back electrode layer 4 is formed to cover photoelectric conversion layer 3 having second separation groove 32 formed therein, as shown in the schematic cross-sectional view of Fig. 12. A conventionally known method such as sputtering, vacuum deposition, or ion plating, for example, may be used as the method for forming back electrode layer 4.

A conductive layer, for example, an Ag (silver) layer, an Al (aluminum) layer, or a stacked structure of these layers, may be used as back electrode layer 4. Back electrode layer 4 also preferably has, on its surface facing photoelectric conversion layer 3, a transparent conductive film through which light can pass, for example, a single layer of an SnO₂ film, an ITO film, a ZnO film, or a film obtained by adding a trace amount of an impurity into any of these layers, or a plurality of layers obtained by stacking a plurality of these layers, in order to improve the conversion efficiency of the thin-film solar battery. Where the transparent conductive film is composed of a plurality of layers, all of the layers may be formed of the same material, or at least one layer may be formed of a material different from that of the others. The thickness of back electrode layer 4 may be not less than 150 nm and not more than 400 nm, for example.

Then, as shown in the schematic cross-sectional view of Fig. 13, straight third separation groove 33 for separating photoelectric conversion layer 3 and back electrode layer 4 is formed, thereby producing a thin-film solar battery. An electrode for current extraction may be formed on back electrode layer 4 or the like of the thin-film solar battery produced in the present embodiment.

Third separation groove 33 may be formed by the laser scribing method, for example. Third separation groove 33 can be formed by the laser scribing method by, for example, directing laser light to a portion of photoelectric conversion layer 3 from the substrate 1 side, and moving the position irradiated with the laser light along the surface of photoelectric conversion layer 3, thereby vaporizing the portion of the region of each of photoelectric conversion layer 3 and back electrode layer 4 irradiated with the laser light. As the laser light used for forming third separation groove 33 by the laser scribing method, the second harmonic wave of YAG laser light or the second harmonic wave of YVO₄ laser light, for example, may be used.

Moreover, third separation groove 33 is also preferably formed by the laser scribing method, in the same manner as second separation groove 32 described above. That is, it is preferable to form third separation groove 33 by the laser scribing method in which solar battery substrate 12 after the formation of back electrode layer 4 is used as the object to be processed, a position to be irradiated with laser light is determined based on temperature information before processing of the object to be processed and distortion information on the object to be processed acquired in advance, and laser light is directed from the substrate 1 side to the determined position to be irradiated with laser light. In this case, third separation groove 33 can be formed with high precision without adjusting the temperature of the object to be processed, thereby allowing a thin-film solar battery to be produced with high production efficiency.

Furthermore, first separation groove 31 is also preferably formed by the laser scribing method, in the same manner as second separation groove 32 described above. That is, it is preferable to form first separation groove 31 by the laser scribing method in which substrate 1 after the formation of transparent conductive film 2 is used as the object to be processed, a position to be irradiated with laser light is determined based on temperature information before processing of the object to be processed and distortion information on the object to be processed acquired in advance, and laser light is directed from the substrate 1 side to the determined position to be irradiated with laser light. In this case, first separation groove 31 can be formed with high precision without adjusting the temperature of the object to be processed, thereby allowing a thin-film solar battery to be produced with high production efficiency.

In the thin-film solar battery produced according to the present embodiment, as shown in the schematic enlarged plan view of Fig. 14, for example, a pitch P 12 between processing center line 31a of first separation groove 31 and processing center line 32a of second separation groove 32, and a pitch P 13 between processing center line 32a of second separation groove 32 and processing center line 33a of third separation groove 33, can each be controlled with high precision to about 120 µm, for example.

Therefore, in the present embodiment, it is unnecessary to adjust the temperature of the object to be processed before forming separation grooves, as in conventional methods, and thus a thin-film solar battery can be produced with high production efficiency.

Moreover, in the present embodiment, the position to be irradiated with laser light in the laser scribing method is determined by assuming how a distortion is generated after the temperature distribution over the surface of the object to be processed has changed from the state before the laser scribing processing to the state after being cooled to room temperature, and thus separation grooves can be formed with high precision by the laser scribing method.

Consequently, according to the method for producing a thin-film solar battery and the laser scribing apparatus in the present embodiment, high production efficiency of the thin-film solar battery can be realized with high-precision processing, without adjusting the temperature of the object to be processed.

While the case where only a single beam of laser light 22 is generated from laser light generator 11 has been described in the present embodiment, a plurality of beams of laser light may be generated each independently at the same time to form a plurality of grooves simultaneously.

Moreover, while the case where control unit 17 determines the position to be irradiated with laser light 22 based on temperature information of the object to be processed and distortion information on the object to be processed has been described in the present embodiment, the position to be irradiated with laser light may also be determined based on information including other items of information, so long as the information includes temperature information and distortion information on the object to be processed.

### EXAMPLES

### <Example>

Initially, as shown in Fig. 1, transparent conductive film 2 made of SnO₂ was formed by thermal CVD as a transparent conductive film on a glass substrate having a rectangular surface measuring 1000 mm in width, 1400 mm in length, and 4 mm in thickness as substrate 1.

Next, as shown in Fig. 2, a plurality of straight first separation grooves 31 extending in the longitudinal direction of substrate 1 were formed at regular spacings in transparent conductive film 2 by the laser scribing method. The fundamental wave of YAG laser light was directed from the substrate 1 side, using a side surface on one side (hereinafter referred to as the "K-side") in the width direction of substrate 1 as the processing reference, thereby removing the irradiated portion of transparent conductive film 2 by vaporization. Here, the irradiation was performed at a temperature of the center of the surface of substrate 1 of around 27°C (room temperature).

Here, first separation grooves 31 may be formed by the laser scribing method using the laser scribing apparatus shown in Fig. 5, in the same manner as second separation grooves 32 described below, by directing the fundamental wave of YAG laser light to a position determined based on temperature information of substrate 1 after the formation of transparent conductive film 2 and distortion information on substrate 1 after the formation of transparent conductive film 2 acquired in advance. Specifically, control unit 17 initially determines a path of the position to be irradiated with the fundamental wave of YAG laser light, based on a temperature distribution over the surface of substrate 1 after the formation of transparent conductive film 2 acquired by infrared thermography and distortion information on substrate 1 after the formation of transparent conductive film 2 acquired in advance and stored therein. Next, the fundamental wave of YAG laser light is directed along the determined path from the substrate 1 side, using the side surface on the K-side in the width direction of substrate 1 as the processing reference, whereby transparent conductive film 2 is processed and first separation groove 31 can be formed therein. This method in which the position (path) to be irradiated with laser light is determined based on the distortion information is especially effective where the temperature of substrate 1 is significantly different from room temperature, for example, where the temperature of substrate 1 after the formation of transparent conductive film 2 is different from room temperature by 10°C or higher.

Next, as shown in Fig. 3, substrate 1 after the formation of first separation groove 31 was ultrasonically cleaned with pure water, and then photoelectric conversion layer 3 was formed to cover transparent conductive film 2, thus forming solar battery substrate 12 having a stacked structure of substrate 1, transparent conductive film 2, and photoelectric conversion layer 3. Photoelectric conversion layer 3 was formed by forming a p layer made of a hydrogenated amorphous silicon semiconductor doped with boron (a-Si:H), an i layer made of a non-doped hydrogenated amorphous silicon semiconductor (a-Si:H), an n layer made of a hydrogenated microcrystalline silicon semiconductor doped with phosphorus (µc-Si:H), a p layer made of a hydrogenated microcrystalline silicon semiconductor (µc-Si:H), an i layer made of a non-doped hydrogenated microcrystalline silicon semiconductor (µc-Si:H), and an n layer made of a hydrogenated microcrystalline silicon semiconductor doped with phosphorus (µc-Si:H) in this order from the substrate 1 side, by plasma CVD under conditions in which the temperature of substrate 1 was 180°C.

Next, as shown in Fig. 4, a plurality of straight second separation grooves 31 extending in the longitudinal direction of substrate 1 were formed in photovoltaic conversion layer 3 by the laser scribing method. Here, second separation grooves 32 were formed by the laser scribing method using the laser scribing apparatus shown in Fig. 5, in which laser light was directed to a position determined based on temperature information of solar battery substrate 12 and distortion information on solar battery substrate 12 acquired in advance.

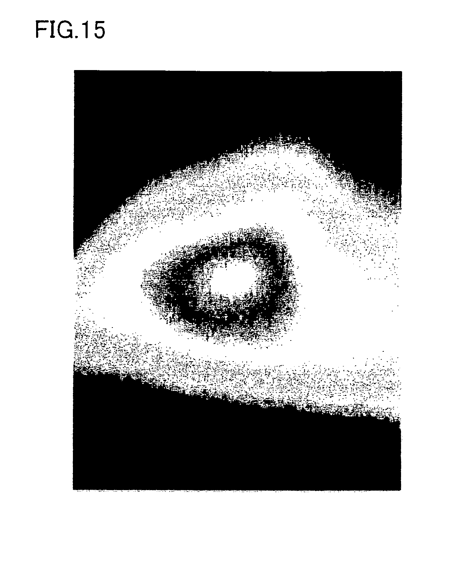

Specifically, above-described solar battery substrate 12 after the formation of photoelectric conversion layer 3 was placed on stage 14 and fixed with substrate position fixing unit 15, and a temperature distribution over a surface of solar battery substrate 12 (surface of substrate 1) was measured by infrared thermography as temperature measuring unit 18. The result is shown in Fig. 15. As shown in Fig. 15, the temperature of the surface of above-described solar battery substrate 12 after the formation of photoelectric conversion layer 3 was confirmed to gradually decrease from the center of the surface of solar battery substrate 12 where the temperature was 50°C (highest temperature) toward around the perimeter thereof.

Next, control unit 17 in the laser scribing apparatus shown in Fig. 5 determined a path of the position to be irradiated with the second harmonic wave of YVO₄ laser light used as laser light 22, based on the above-described temperature distribution over the surface of solar battery substrate 12 acquired by infrared thermography and distortion information on solar battery substrate 12 acquired in advance and stored therein.

The second harmonic wave of YVO₄ laser light was next generated from laser light generator 11 while stage 14 is being moved by way of drive units 16a, 16b, in such a manner that the second harmonic wave of YVO₄ laser light was directed from the substrate 1 side along the above-determined path of the position to be irradiated with the second harmonic wave of YVO₄ laser light. Consequently, second separation grooves 32 were formed as a result of vaporization of the portion of photoelectric conversion layer 3 irradiated with the second harmonic wave of YVO₄ laser light. The irradiation of the second harmonic wave of YVO₄ laser light was here again performed using the side surface on the K-side in the width direction of substrate 1 as the processing reference. Solar battery substrate 12 after the formation of second separation grooves 32 was subsequently taken out of the laser scribing apparatus shown in Fig. 5.

Next, as shown in Fig. 12, back electrode layer 4 was formed on the surface of photoelectric conversion layer 3 of solar battery substrate 12 after the formation of second separation grooves 32. Back electrode layer 4 was formed here by forming a ZnO film and an Ag film in this order from the photoelectric conversion layer 3-side by magnetron sputtering, under conditions in which the temperature of substrate 1 was 140°C.

Next, as shown in Fig. 13, a plurality of straight third separation grooves 33 extending in the longitudinal direction of substrate 1 were formed in photoelectric conversion layer 3 by the laser scribing method, thereby forming a thin-film solar battery according to the Example having a structure in which a plurality of unit solar cells were integrated and connected in series on substrate 1. Here, third separation grooves 33 were formed by the laser scribing method using the laser scribing apparatus shown in Fig. 5, in the same manner as second separation grooves 32, by directing laser light to a position determined based on temperature information of solar battery substrate 12 after formation of back electrode layer 4 and distortion information on solar battery substrate 12 after formation of back electrode layer 4 acquired in advance.

Specifically, control unit 17 initially determined a path of the position to be irradiated with the second harmonic wave of YVO₄ laser light, based on a temperature distribution over the surface of solar battery substrate 12 after the formation of back electrode layer 4 acquired by infrared thermography and distortion information on solar battery substrate 12 after the formation of back electrode layer 4 acquired in advance and stored therein. Next, the second harmonic wave of YVO₄ laser light was directed along the determined path from the substrate 1 side, using the side surface on the K-side in the width direction of substrate 1 as the processing reference, thereby removing by vaporization the region of each of photoelectric conversion layer 3 and back electrode layer 4 irradiated with the laser light. Here, the irradiation was performed at a temperature of the center of the surface of substrate 1 of around 27°C (room temperature).

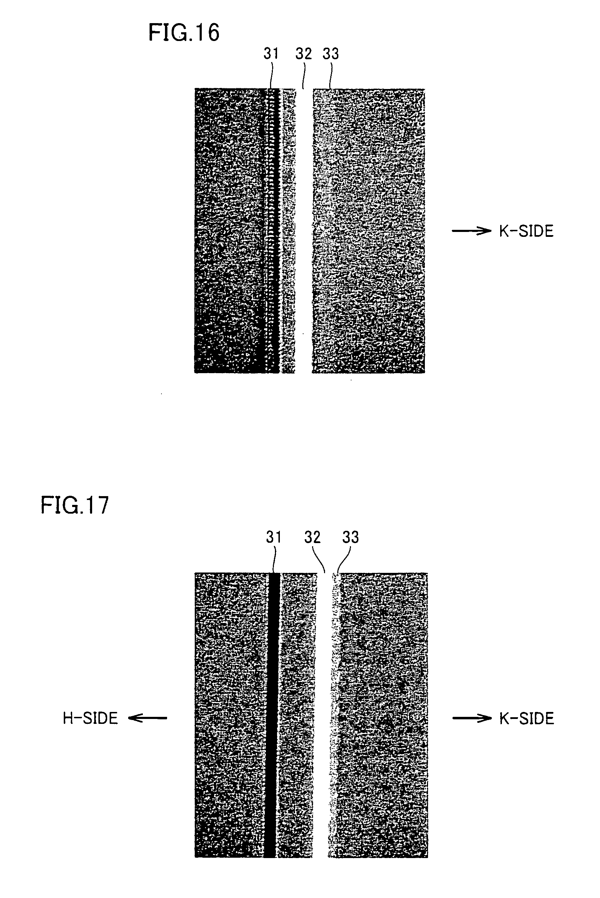

Fig. 16 shows a photograph of the thin-film solar battery according to the Example, taken from the substrate 1 side using an optical microscope. As shown in Fig. 16, in the solar battery according to the Example, third separation groove 33, second separation groove 32, and first separation groove 31 were formed in order from the K-side in the width direction of substrate 1, without coinciding with one another, and therefore, it was confirmed that the thin-film solar battery was produced as designed.

### <Comparative Example>

A thin-film solar battery according to Comparative Example was produced as in the Example, except that when forming each of second separation groove 32 and third separation groove 33, the path of the position to be irradiated with laser light was not determined by control unit 17 based on temperature information of the objects to be processed (solar battery substrate 12, and solar battery substrate 12 after the formation of back electrode layer 4) and distortion information of the objects to be processed, and the path of the position to be irradiated with laser light was not corrected.

Fig. 17 is a photograph of the thin-film solar battery according to the Comparative Example, taken from the substrate 1 side using an optical microscope. As shown in Fig. 17, in the solar battery according to the Comparative Example, second separation groove 32 and third separation groove 33 coincided with each other, and third separation groove 33 was not formed sufficiently, and thus a portion where back electrode layers 4 of adjacent unit solar cells become shorted to each other was found.

Furthermore, in the Comparative Example, where second separation groove 32 and third separation groove 33 were formed by directing the laser light using, as the processing reference, a side surface on a side opposite to the K-side (H-side) in the width direction of substrate 1, first separation groove 31 and second separation groove 32 coincided with each other.

Therefore, the position to be irradiated with laser light is preferably determined in consideration of the side to be used as the processing reference in the width direction of substrate 1, and the direction in which unit solar cells are integrated.

It should be understood that the embodiments and examples disclosed herein are illustrative and non-restrictive in every respect. The scope of the present invention is defined by the terms of the claims, rather than by the foregoing description, and is intended to include any modifications within the scope and meaning equivalent to the terms of the claims.

### INDUSTRIAL APPLICABILITY

The present invention can be utilized as a method for producing a photoelectric conversion device and a light beam irradiation processing apparatus.

### REFERENCE SIGNS LIST

1: substrate; 2: transparent conductive film; 3: photoelectric conversion layer; 10: laser beam irradiation apparatus; 11: laser light generator; 12: solar battery substrate; 12a: sample; 13: optical unit; 14: stage; 15: substrate position fixing unit; 16a, 16b: drive unit; 17: control unit; 18: temperature measuring unit; 19: temperature information recording unit; 20: mirror; 21: lens; 22: laser light; 23: base; 31: first separation groove; 31a: processing center line; 32: second separation groove; 32a: processing center line; 33: third separation groove; 33a: processing center line; 42: path; 42a: processing center line; 51: conveyor; 52: infrared thermography; 53: infrared radiation thermometer; 100: glass substrate.

## Claims

1. A method for producing a photoelectric conversion device comprising the steps of:
acquiring temperature information on an object to be processed (12) including a substrate (1) and a film (2, 3) formed on the substrate (1); and
processing said object to be processed (12) by directing a light beam (22) to said object to be processed (12) subsequent to the step of acquiring said temperature information, thereby processing a region of said object to be processed (12) irradiated with said light beam (22),
in the step of processing said object to be processed (12), said light beam (22) being directed to a position determined based on information including said temperature information and distortion information acquired in advance.

2. The method for producing a photoelectric conversion device according to claim 1, wherein
information on a temperature distribution over a surface of said object to be processed (12) or a temperature at at least one point of the surface of said object to be processed (12) is acquired in the step of acquiring said temperature information.

3. The method for producing a photoelectric conversion device according to claim 1 or 2, wherein
said light beam (22) is directed from a substrate (1) side in the step of processing said object to be processed (12).

4. A light beam irradiation processing apparatus for processing an object to be processed (12) including a substrate (1) and a film (2, 3) formed on the substrate (1) by directing a light beam (22) to said object to be processed (12), comprising:
a light beam generating portion (11) for directing said light beam (22) to said object to be processed (12);
a temperature information acquiring portion (18, 52, 53) for acquiring temperature information on said object to be processed (12) before directing said light beam (22);
a drive portion (16a, 16b) capable of changing a position of said object to be processed (12); and
a control portion (17) capable of controlling said light beam generating portion (11) and said drive portion (16a, 16b) in such a manner that said light beam (22) can be directed to a position determined based on information including said temperature information acquired by said temperature information acquiring portion (18, 52, 53) and distortion information stored therein.

5. A light beam irradiation processing apparatus for processing an object to be processed (12) including a substrate (1) and a film (2, 3) formed on the substrate (1) by directing a light beam (22) to said object to be processed (12), comprising:
a temperature information acquiring portion (18, 52, 53) for acquiring temperature information on said object to be processed (12);
a processing portion (13) for processing said object to be processed (12); and
a transport portion (51) for transporting said object to be processed (12) from said temperature information acquiring portion (18, 52, 53) to said processing portion (13),
said processing portion (13) including
a light beam generating portion (11) for directing said light beam (22) to said object to be processed (12);
a drive portion (16a, 16b) capable of changing a position of said object to be processed (12); and
a control portion (17) capable of controlling said light beam generating portion (11) and said drive portion (16a, 16b) in such a manner that said light beam (22) can be directed to a position determined based on information including said temperature information acquired by said temperature information acquiring portion (18, 52, 53) and distortion information stored therein.
